# EUROPEAN PATENT SPECIFICATION

(11) **EP 3 428 954 B1**
(45) Date of publication and mention of the grant of the patent: **19.05.2021**
(21) Application number: 17181342.1
(22) Date of filing: 14.07.2017
(51) Int. Cl.: H01L 21/56, H01L 21/60, H01L 23/485, H01L 23/48, H01L 21/67, H01L 23/49

(54) **METHOD FOR ESTABLISHING A CONNECTION BETWEEN TWO JOINING PARTNERS**
VERFAHREN ZUR HERSTELLUNG EINER VERBINDUNG ZWISCHEN ZWEI VERBINDUNGSPARTNERN
PROCÉDÉ POUR ÉTABLIR UNE CONNEXION ENTRE DEUX PARTENAIRES D'ASSEMBLAGE

(43) Date of publication of application: 16.01.2019
(73) Proprietor: Infineon Technologies AG, 85579 Neubiberg (DE)
(72) Inventor: Craes, Fabian, 59494 Soest (DE); Hartmann, Steffen, 59505 Bad Sassendorf (DE)
(74) Representative: Westphal, Mussgnug Patentanwälte & Partner mbB

(56) References cited:
- JP-A- 2003 077 953
- US-A1- 2011 020 983
- US-A1- 2014 224 409

## Description

### TECHNICAL FIELD

The present invention relates to a method for establishing a connection between two joining partners, in particular for establishing a sintered connection between two joining partners.

### BACKGROUND

In many different (technical) fields, different components or objects are connected to each other by means of sintered connections. For example, power semiconductor module arrangements often include a base plate within a housing. At least one substrate is usually arranged on the base plate. A semiconductor arrangement including a plurality of controllable semiconductor elements (e.g., two IGBTs in a half-bridge configuration) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer is usually attached to the base plate. When mounting the controllable semiconductor devices to the substrate, e.g., using a sintering process, the semiconductor devices are usually pressed onto the first metallization layer with a certain amount of force and under the influence of high temperatures, wherein the temperatures usually lie at about 300° C and more. The semiconductor substrate and the base plate, as well as other components of a power semiconductor module arrangement, may also be connected to each other with sintered connections.

Different sintering methods are known. Known sintering methods, however, have several disadvantages, such as an uneven distribution of the applied force, high costs, or contamination of seals and of the connecting layer during the process. Document US 2014/0224409 A1 discloses a system for producing an electrical module. The system includes a pressure chamber configured to receive a first body, a second body, and a sinter material therebetween. The system further includes a pressure generator configured to apply non-mechanical pressure in the pressure chamber to form the electrical module by attaching the first body to the second body using the sinter material. The pressure chamber is configured to enclose the first body over the second body. Furthermore, the pressure chamber includes a bottom opening configured to receive at least the first body. The non-mechanical pressure can include gas pressure. Document US 2011/0020983 A1 discloses a flip-chip mounting apparatus that has a shield film on the side of a pressurizing film of a tool protection sheet. When a semiconductor chip is heated and pressurized via the tool protection sheet, the pressurizing film is released from a mold by a sheet fixing jig, and is expanded by a pressurizing/heating tool to abut against an insulating resin film protruding from the periphery of the semiconductor chip and cure the insulating resin film with an external pressure being applied.

Document JP 2003 077953 A discloses a flip-chip mounting method. A wiring board has a plurality of electrode terminals. A semiconductor chip has a plurality of connection terminals. A flip-chip mounting method is described for electrically connecting the electrode terminals of the wiring board and the connection terminals of the semiconductor chip via an anisotropic conductive film. After the semiconductor chip is positioned and arranged with respect to the wiring board, the semiconductor chip is heated and the anisotropic conductive film is semi-hardened to a degree of curing of 15 to 30%. After this step, the semiconductor chip on the wiring board is arranged in a pressure vessel and isotropic pressure is applied using hydraulic oil in the pressure vessel to at least the semiconductor chip and the anisotropic conductive film, and the at least one anisotropic film is heated. By curing the anisotropic conductive film, one or more of the semiconductor chips are fixed on the wiring substrate.

There is a need for an improved method which reduces or avoids the mentioned disadvantages.

### SUMMARY

The method of the present invention as defined in claim 1 includes arranging a first joining partner in a joining chamber, the first joining partner comprising a first surface and a second surface opposite the first surface, the first surface facing a bottom surface of the joining chamber, arranging a second joining partner on the second surface of the first joining partner, with a first pre-layer being arranged between the first joining partner and the second joining partner, filling the joining chamber with a liquid, thereby applying a pressure to the joining partners such that the second joining partner is pressed onto the first joining partner, thereby compressing the pre-layer resulting in a connecting layer which forms a firm substance-to-substance bond between the first joining partner and the second joining partner. The liquid comprises a liquid polymer, and the liquid is solidified or hardened while applying pressure to the joining partners.

The invention may be better understood with reference to the following drawings and the description. The components in the figures are not necessarily to scale, emphasis instead being placed upon illustrating the principles of the invention. Moreover, in the figures, like reference numerals designate corresponding parts throughout the different views.

### BRIEF DESCRIPTION OF THE DRAWINGS

Figure 1 is a cross-sectional view of a conventional arrangement for connecting two joining partners.
Figure 2, including Figures 2A to 2D, illustrates an example of a method for establishing a connection between two joining partners in accordance with an embodiment of the present invention.
Figure 3 is a cross-sectional view of an apparatus for establishing a connection between two joining partners, with two joining partners arranged therein.
Figure 4 is a cross-sectional view of an apparatus for establishing a connection between two joining partners, with two joining partners arranged therein.
Figure 5, including Figures 5A to 5D, illustrates another example of a method for establishing a connection between two joining partners in accordance with another embodiment of the present invention.
Figure 6, including Figures 6A to 6D, illustrates another example of a method for establishing a connection between two joining partners in accordance with another embodiment of the present invention.

### DETAILED DESCRIPTION

In the following detailed description, reference is made to the accompanying drawings. It is to be understood that the features and principles described with respect to the various examples may be combined with each other, unless specifically noted otherwise. In the description as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

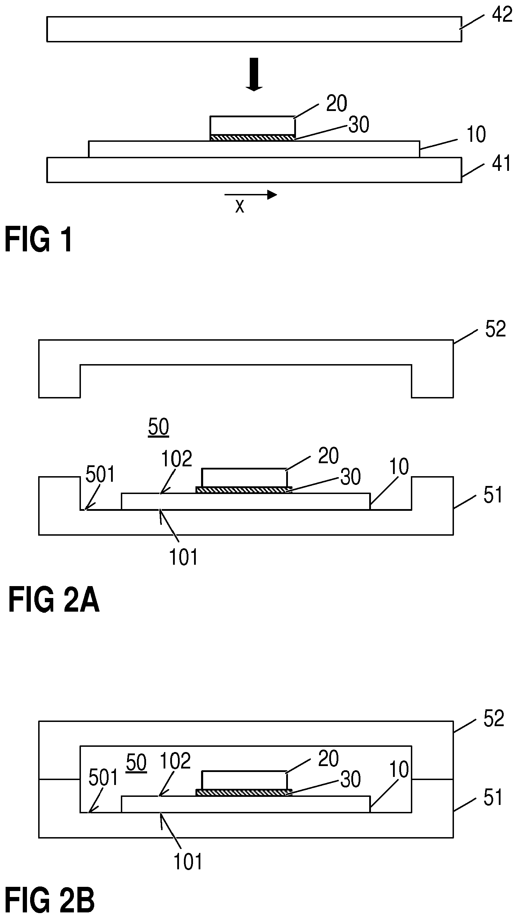

Referring to Figure 1, a cross-sectional view of a conventional arrangement for establishing a connection between two joining partners 10, 20 is illustrated. The arrangement comprises a first mounting tool 41 and a second mounting tool 42. A first joining partner 10 is arranged on a top surface of the first mounting tool 41. A second joining partner 20 is arranged on a surface of the first joining partner 10 which faces away from the first mounting tool 41. A pre-layer 30 is arranged between the first joining partner 10 and the second joining partner 20. Usually, the first joining partner 10 consists of or includes a metal. For example, a top surface of the first joining partner 10 which faces away from the first mounting tool 41 may consist of or include a metal. A bottom surface of the second joining partner 20, which faces the first joining partner 10, generally also, at least partially, consists of or includes a metal. The pre-layer 30 may be formed of a paste including a metal powder, e.g., a silver powder. The particles of the metal powder within the paste may already be slightly connected to each other. The paste may be wet and have a viscous consistency. It is, however, also possible that the paste is at least slightly dried (moisture at least partially removed from paste) when arranging the second joining partner 20 on the pre-layer 30. The second mounting tool 42 usually has a flat lower surface. During the mounting process, the second mounting tool 42 is pressed onto the second joining partner 20 in order to apply pressure to the second joining partner 20. The second joining partner 20 is thereby pressed onto the first joining partner 10. Under pressure, the pre-layer 30 is compressed and forms a firm substance-to-substance bond between the first joining partner 10 and the second joining partner 20. The arrangement may additionally be heated during the mounting process. Such a process, which is often called hard punch process, however, has several drawbacks. Often, more than one second joining 20 partner is mounted onto the top surface of the first joining partner 10 at the same time (not illustrated). Different second joining partners 20 may be arranged next to each other on the same first joining partner 10 or on different first joining partners. If the different second joining partners 20 and/or different first joining partners 10 do not each have the same height, this may cause problems, because the second mounting tool 42 might not apply the same force/pressure to each of the second joining partners 20.

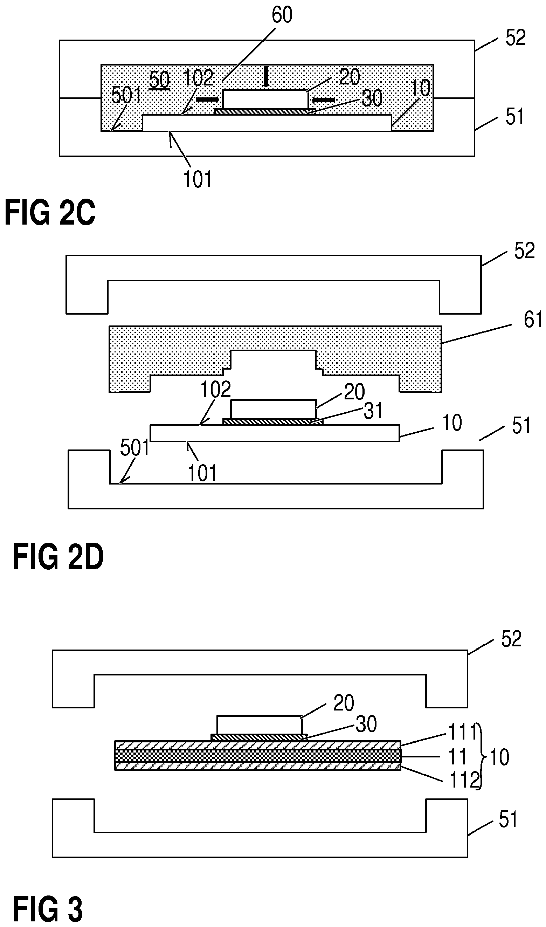

The first joining partner 10, the pre-layer 30 and the second joining partner 20 form a stack. A length of the pre-layer 30 in a horizontal direction x may be essentially the same as the length of the second joining partner 20 in the same horizontal direction x, as is schematically illustrated in Figure 1. However, it is also possible that the length of the pre-layer 30 in a horizontal direction x is greater than the length of the second joining partner 20 in the same horizontal direction x (see, e.g., Figure 2), taking into account tolerances that might occur during production. Several such stacks may be arranged next to each other, wherein each stack may include a separate first joining partner 10 or each stack may include the same first joining partner 10. In some known methods, a compensation layer is provided between the at least one stack and the second mounting tool 42 to compensate any height differences between the different stacks. Such compensation layers may include a silicone pillow, for example. Such silicone pillows distribute the pressure that is applied by the second mounting tool 42 essentially equally between the different stacks irrespective of their heights. Such sintering processes using a silicone pillow or other compensation layers, however, are limited by fatigue and degradation of the pillow or compensation layer. Other methods use an additional protection layer (in addition to the compensation layer) which is configured to prevent damages or contaminations of the second joining partner 20 which may be caused by the second mounting tool 42 or by the compensation layer, for example. Due to a limited curvature, such compensation and protection layers may lead to an inhomogeneous force/pressure that is applied to any areas of the pre-layer 30 that are not boundary areas adjoining the second joining partner 20. In other words, a relatively homogenous force may be applied to areas of the pre-layer 30 which are arranged below the second joining partner 20. An inhomogeneous force, however, may be applied to any areas which protrude from below the second joining partner 20.

The above-mentioned methods further have the disadvantage that the porosity of the resulting connection layer (compressed pre-layer 30) may not be homogenous. An actual porosity of the connection layer may differ from a desired porosity. The described methods have several further drawbacks. Other known methods also have various disadvantages. For example, height differences between closely neighboring joining partners 20 usually prevent a homogeneous force/pressure distribution, even if pillows or compensation layers are used. The anisotropic pressure distribution usually sets limits to the geometric arrangement of joining partners.

Other methods are known where a gas pressure chamber is used to apply high pressure to the second joining partner 20. The joining partners 10, 20 are placed inside the pressure chamber. By increasing the gas pressure inside the chamber, the second joining partner 20 is pressed onto the first joining partner 10. Under this pressure, the pre-layer 30 between the joining partners 10, 20 is compressed and forms a firm substance-to-substance bond between the first joining partner 10 and the second joining partner 20. However, such methods require a sealing of the pre-layer 30 against the gas pressure and further require a sophisticated sealing of the gas pressure chamber against the high gas pressure present inside the chamber. Such seals are usually expensive and are usually not reusable (a new seal has to be used for each subsequent process cycle). Other known methods also have various disadvantages.

An embodiment of the present invention which overcomes or at least reduces the above-mentioned disadvantages is described referring to Figure 2. Referring to Figure 2A, the joining partners 10, 20 are arranged in a joining chamber 50. In Figure 2A, the joining chamber 50 is open to allow the joining partners 10, 20 to be arranged inside the chamber 50. For example, the joining chamber 50 may be formed by a first, lower housing component 51 and a second, upper housing component 52. When the second housing component 52 is lifted from the first housing component 51, the inside of the chamber 50 is accessible. The chamber 50 has a bottom surface 501. The first joining partner 10 is arranged on the bottom surface 501. The first joining partner 10 has a first surface 101 and a second surface 102 opposite to the first surface 101. The first joining partner 10 is arranged on the bottom surface 501 such that the first surface 101 of the first joining partner 10 faces the bottom surface 501 of the joining chamber 50. The pre-layer 30 is arranged on the second surface 102 of the first joining partner 10. The second joining partner 20 is arranged on the pre-layer 30 such that the pre-layer 30 is arranged between the first joining partner 10 and the second joining partner 20.

The second housing component 52 may then be lowered onto the first housing component 51 to close the chamber 50. This is, however, only an example. The joining chamber 50 may be formed in any other suitable way. For example, the chamber 50 may be formed by an essentially continuous case which has one or more openings which allow to access the chamber 50 and to arrange the joining partners 10, 20 inside the chamber 50. The chamber 50 may be closed and sealed while performing the sintering process. Figure 2B schematically illustrates the joining partners 10, 20 inside the closed chamber 50. Referring to Figure 2C, the closed (and sealed) chamber 50 is filled with a liquid 60. In particular, the chamber 50 may be completely filled with the liquid 60 with a certain pressure. The liquid 60 therefore applies a pressure to the components that are arranged within the chamber 50 (joining partners 10, 20 and pre-layer 30). For example, a pressure is applied on any exposed surfaces of the components (joining partners 10, 20, pre-layer 30) inside the chamber 50. In this way, the second joining partner 20 is pressed onto the first joining partner 10 with the pre-layer 30 stacked in between, thereby compressing the pre-layer 30. In this way a compressed connecting layer 31 is formed between the first joining partner 10 and the second joining partner 20. The connecting layer 31 forms a firm substance-to-substance bond between the first joining partner 10 and the second joining partner 20. The pressure within the chamber is great enough in order to perform the sintering process and permanently connect the joining partners 10, 20 to each other. The pressure may be at least 10MPa (100bar), at least 20MPa (200bar), or at least 30MPa (300bar), for example. The pressure may be a quasi-hydrostatic pressure.

The pressure that is applied by the liquid 60 is applied essentially evenly to the exposed surfaces of the components. For example, a pressure is applied to a top surface of the second joining partner 20 and an equal pressure is applied to any exposed side surfaces of the second joining partner 20. This is schematically illustrated with bold arrows in Figure 2C. The same applies for any exposed surfaces of the first joining partner 10 and the pre-layer 30 as well as to the sidewalls of the chamber 50.

The sintering process may further include heating the chamber 50 with the joining partners 10, 20 and the pre-layer 30 arranged therein. For example, the components may be heated to up to 300°C, up to 400°C, or up to 500°C while applying pressure to the components. This generally enhances the connection (sintering) process. To generate an appropriate heat, the chamber 50 may include a heating element (not illustrated). For example, a heating element may be arranged on the bottom of the chamber. A heating element could be integrated in the first housing component 51, for example.

The liquid 60 is solidified or hardened during the mounting process. The liquid 60 is a liquid polymer. For example, the liquid polymer may be a thermoplastic polymer or a thermosetting polymer.

After the connecting layer 31 has been formed by compressing and hardening the pre-layer 30 and the second joining partner 20 has been permanently connected to the first joining partner 10, the connected joining partners 10, 20 may be removed from the chamber 50. The solidified or hardened liquid 60 may not be permanently connected to the joining partners 10, 20 after the process and, therefore, may be separated from the joining partners 10, 20. The step of removing the joining partners 10, 20 from the joining chamber 50 and removing the solidified or hardened liquid 60 is schematically illustrated in Figure 2D. To remove the joining partners 10, 20 from the chamber 50, the chamber 50 may be opened.

The first joining partner 10 may be a substrate, for example. As is illustrated in Figure 3, a substrate generally includes a dielectric insulation layer 11, a first (structured) metallization layer 111 attached to the dielectric insulation layer 11, and a second (structured) metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AlN, SiC, BeO or Si₃N₄. For instance, the substrate may, e.g., be a Direct Copper Bonding (DCB) substrate, a Direct Aluminum Bonding (DAB) substrate, or an Active Metal Brazing (AMB) substrate. The substrate may also be a conventional printed circuit board (PCB) having a non-ceramic dielectric insulation layer 11. For instance, a non-ceramic dielectric insulation layer 11 may consist of or include a cured resin.

The second joining partner 20 may be a semiconductor body, for example. Generally, one or more semiconductor bodies may be arranged on a substrate. Each of the semiconductor bodies arranged on the substrate may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable semiconductor element.

One or more semiconductor bodies may form a semiconductor arrangement on a substrate. In Figure 3, however, only one semiconductor body 20 is exemplarily illustrated. The second metallization layer 112 of the substrate 10 in Figure 3 is a continuous layer. The first metallization layer 111 also is a continuous layer in the example illustrated in Figure 3. However, the first metallization layer 111 could also be a structured layer. "Structured layer" means that the first metallization layer 111 is not a continuous layer, but includes recesses between different sections of the layer. Different semiconductor bodies 20 may be mounted to the same or to different sections of the first metallization layer 111. Different sections of the first metallization layer may have no electrical connection or may be electrically connected to one or more other sections using, e.g., bonding wires. Electrical connections may also include connection plates or conductor rails, for example, to name just a few examples. Each of the one or more semiconductor bodies 20 may be electrically and mechanically connected to the substrate 10 by an electrically conductive connection layer 31 (compressed pre-layer 30), as has been described above by means of Figure 2. Generally, it is also possible that the second metallization layer 112 is a structured layer.

According to another example (not illustrated), the second joining partner 20 may be a substrate and the first joining partner 10 may be a base plate. In some power semiconductor module arrangements, more than one substrate may be arranged on a single base plate. According to an even further example (not illustrated), the first joining partner 10 may be a cooling element or heat sink and the second joining partner 20 may be a base plate or a substrate. According to an even further example (not illustrated), the second joining partner 20 may be a semiconductor wafer including a plurality of semiconductor dies. The semiconductor wafer may be connected to a first joining partner 10 (e.g., substrate or base plate) while the different semiconductor dies are still connected to each other. The semiconductor dies may be separated only after connecting the semiconductor wafer to a substrate or a base plate, for example.

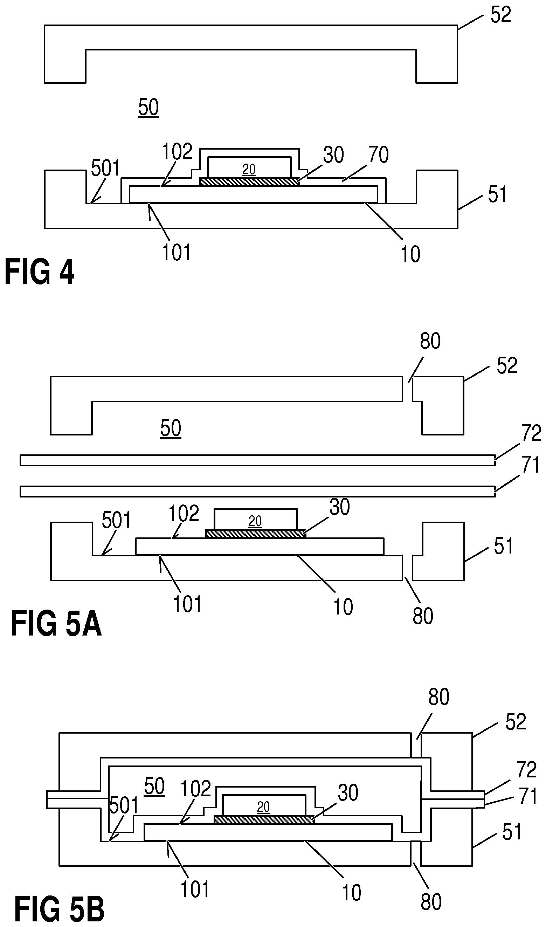

As has been described with reference to Figure 2D above, the liquid 60, which is solidified or hardened during the mounting process, may be separated from the joining partners 10, 20 after the mounting process. Generally, applying a pressure inside the chamber 50 by inserting the liquid 60 and thereby solidifying or hardening the liquid 60 may cause the liquid 60 to stick to the joining partners 10, 20. Therefore, it may be difficult or even impossible to separate the solidified or hardened liquid 60 after connecting the joining partners 10, 20 to each other. Referring to Figure 4, a protective layer 70 may be arranged on the exposed surfaces of the joining partners 10, 20 as well as on any exposed surfaces of the pre-layer 30. The protective layer 70 may be arranged between the stack (formed by the joining partners 10, 20 and the pre-layer 30) and the free volume of the chamber 50, which is to be filled with the liquid 60. The protective layer 70 may be configured to prevent the liquid 60 from sticking to the joining partners 10, 20 and to the exposed parts of the pre-layer 30. The protective layer 70 may also be configured to prevent the liquid 60 from contaminating the pre-layer 30, for example. As the pre-layer 30, as well as the resulting compressed connecting layer 31, have a certain porosity, the liquid 60 may penetrate into voids that may be present in the pre-layer 30 and/or the connecting layer 31. This may alter the consistency and the quality of the pre-layer 30 and the connecting layer 31 in an unwanted way.

The protective layer 70 may include a lubricant like an oil or fat or an anti-tarnish coating, for example. The protective layer 70 may be applied to the joining partners 10, 20 and the exposed surfaces of the pre-layer 30 in any suitable way, e.g., spraying, sputtering, dipping, or brushing. The further mounting process corresponds to the process that has been described referring to Figures 2B to 2D above. The protective layer 70 may subsequently be removed from the joining partners 10, 20 and from the exposed surfaces of the connecting layer 31, after the mounting process has been completed and the (solidified or hardened) liquid 60 has been removed. Any suitable method may be used to remove the protective layer 70. The protective layer 70 may alternatively or additionally be applied to any inner surface of the joining chamber 50 to prevent the liquid 60 from sticking to the walls of the chamber 50, for example.

Referring to Figure 5A, a first foil 71 may be used to provide a protective layer. In the example of Figure 5A, the first foil 71 is arranged between the first housing component 51, and the second housing component 52. When the chamber 50 is closed, the first foil 71 divides the total volume of the chamber 50 in a first partial volume and a second partial volume. The joining partners 10, 20 with the pre-layer 30 arranged there between are arranged in the first partial volume. The first foil 71 may be arranged within the chamber 50 such that there is no passage between the first partial volume and the second partial volume and such that it does not enable any gas exchange between the partial volumes. A second foil 72 may be arranged within the chamber 50. The second foil 72 may be arranged adjacent to the first foil 71 such that it lies flat against the first foil 71.

An inlet 80 may be provided for each partial volume. Through the inlets 80, a vacuum may be generated in both the first partial volume and the second partial volume. Any air or gas within the partial volumes thereby may be removed and the first foil 71 and the second foil 72 may each be drawn in by the respective vacuum. The first foil 71 thus lies flat against the exposed surfaces of the joining partners 10, 20 and of the pre-layer 30 after all air has been removed from the first partial volume. The first foil 71 may further lie flat against any exposed parts of the bottom surface 501 and any side surfaces of the first partial volume of the chamber 50, as is schematically illustrated in Figure 5B. In this way, also any surfaces of at least a part of the chamber 50 are no longer exposed to the liquid 60. By removing any air or gas from the second partial volume, also any other exposed surfaces of the chamber 50 within the second partial volume are no longer exposed to the liquid 60, because, as is schematically illustrated in Figure 5B, the second foil 72 lies flat against any surfaces of the chamber 50 within the second partial volume.

The chamber 50, so to speak, is then formed by the resulting volume between the first foil 71 and the second foil 72. The first foil 71 and the second foil 72 also cover the inlets 80, thereby sealing the inlets such that no fluid or liquid may enter the chamber 50 or leak out of the chamber 50. The inlets 80, however, may alternatively or additionally be sealed in any other suitable way. After sealing the chamber 50, the chamber 50 may then be filled with a liquid 60. In particular, the chamber 50 may be completely filled with the liquid 60 with a certain pressure. The liquid 60 therefore applies a pressure to the components that are arranged within the chamber 50. For example, a pressure is applied on any exposed surfaces of the components (joining partners 10, 20, pre-layer 30) inside the chamber 50. In this way, the second joining partner 20 is pressed onto the first joining partner 10 with the pre-layer 30 arranged in between, thereby compressing the pre-layer 30. In this way a compressed connecting layer 31 is formed between the first joining partner 10 and the second joining partner 20. The connecting layer 31 forms a firm substance-to-substance bond between the first joining partner 10 and the second joining partner 20. The pressure within the chamber 50 may be great enough in order to perform the sintering process and permanently connect the joining partners 10, 20 to each other. The pressure may be at least 10MPa (100bar), at least 20MPa (200bar), or at least 30MPa (300bar), for example.

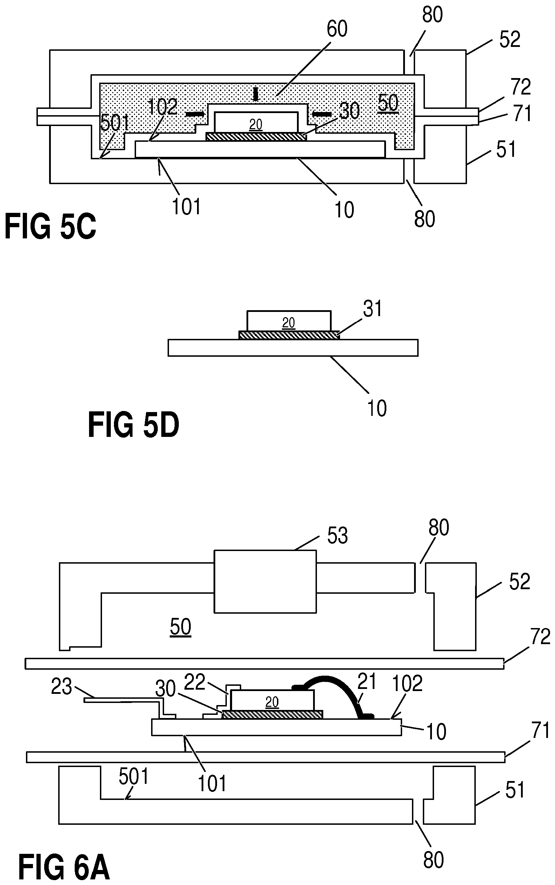

The chamber 50 which is filled with the liquid 60 is schematically illustrated in Figure 5C. The pressure that is applied by the liquid 60 is applied essentially evenly to all the exposed surfaces of the components. For example, a pressure is applied to a top surface of the second joining partner 20 and an equal pressure is applied to any exposed side surfaces of the second joining partner 20 as has been described with respect to Figure 2C before. The same applies for any exposed surfaces of the first joining partner 10 and the pre-layer 30 as well as to any surfaces of the chamber 50.

The sintering process may further include heating the chamber with the joining partners 10, 20 and the pre-layer 30. For example, the components may be heated to up to 300°C, up to 400°C, or up to 500°C while applying pressure to the components. This generally enhances the sintering process. To generate an appropriate heat, the chamber 50 may include a heating element (not illustrated). For example, a heating element may be arranged on the bottom of the chamber. A heating element could be integrated in the first housing component 51, for example.

The liquid 60 is solidified or hardened during the mounting process (sintering process). The liquid 60 is a liquid polymer. For example, the liquid polymer may be a thermoplastic polymer or a thermosetting polymer.

After the connecting layer 31 has been formed by compressing and hardening the pre-layer 30 and the second joining partner 20 has been permanently connected to the first joining partner 10, the connected joining partners 10, 20 may be removed from the chamber 50. The solidified or hardened liquid 60 may not be permanently connected to the first foil 71 after the process and may be separated from the first foil 71 and, therefore, from the joining partners 10, 20. Figure 5D schematically illustrates the permanently connected joining partners 10, 20 after removing them from the chamber 50 and after removing the solidified or hardened liquid 60 and the first foil 71.

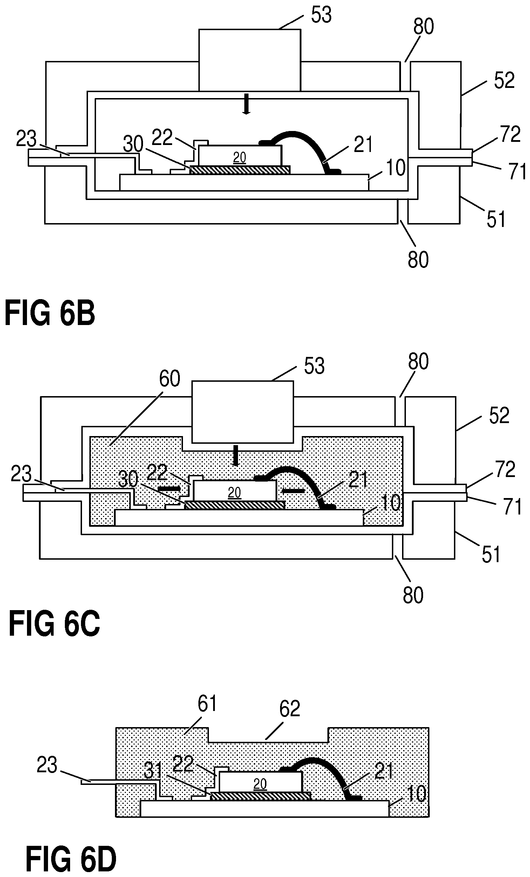

Now referring to Figure 6, a further example of a method will be described. Figure 6A schematically illustrates a chamber 50 in which a stack is arranged, the stack including a first joining partner 10, a second joining partner 20 and a pre-layer 30 arranged between the first joining partner 10 and the second joining partner 20. In the example of Figure 6A, the first joining partner 10 is a substrate and the second joining partner 20 is a semiconductor body. The second joining partner 20 may be electrically connected to the first joining partner 10 by means of any suitable electrical connection. For example, the second joining partner 20 may be electrically connected to the first joining partner 10 via a bonding wire 21. It is also possible to electrically connect the second joining partner 20 and the first joining partner 10 via an electrically conducting layer 22. An electrical conducting layer 22, for example, may be established by a pre-layer or a preattached electrical connection on a pre-layer during the same process that is used to establish the connecting layer 31. In the example of Figure 6A, two different electrical connections 21, 22 are exemplarily illustrated. This is, however, for explanation purposes only. A semiconductor body may be electrically connected to a substrate via one or more bonding wires 21, without any further electrically conducting layer 22 being present. According to another example, a semiconductor body is electrically connected to a substrate via one or more electrically conducting layers 22, without any bonding wires 21 being present. According to an even further example, no bonding wires 21 and electrically conducting layers 22 are used to electrically connect the joining partners 10, 20.

For example, the first joining partner 10 and the second joining partner 20 may be electrically connected to each other via the pre-layer 30/connecting layer 31. A semiconductor body may include a chip pad metallization, e.g., a source, drain, anode, cathode or gate metallization. A chip pad metallization generally provides a contact surface for electrically connecting a semiconductor body. The chip pad metallization may electrically contact the pre-layer 30/connecting layer 31, a bonding wire 21, or an electrically conducting layer 22, for example. A chip pad metallization may consist of or include a metal such as aluminum, copper, gold or silver, for example. Any electrical connections 21, 22 may also consist of or include a metal such as copper, aluminum, gold, or silver, for example.

A connecting element 23 may be arranged on the first joining partner 10. The connecting element 23 may later provide an external connection of the power semiconductor module arrangement. For example, when the substrate (first joining partner 10) later is arranged on a base plate and the arrangement including the base plate and the substrate is placed in a housing, the connecting element 23 may extend though the housing to provide an electrical connection between the inside and the outside of the housing.

The chamber 50 that is illustrated in Figure 6 may be similar to the chamber 50 which has been described above with reference to Figures 2 and 5. When placing the stack (first joining partner 10, second joining partner 20, pre-layer 30) with the (optional) electrical connections 21, 22, 23 inside the chamber 50, a first foil 71 and a second foil 72 may be provided in the same way as has been described above with respect to Figure 5A. However, especially if bonding wires 21 are used as electrical connections, the electrical connections may be damaged when a vacuum is generated to draw the first foil 71 towards the joining partners 10, 20 and towards the bottom surface 501 of the chamber 50. Moreover, cavities may be formed below any bonding wires 21 or other electrical connections if the first foil 71 is prevented from lying flat against the exposed surfaces of the joining partners 10, 20 or the pre-layer 30. Therefore, the first foil 71 may be arranged between the first joining partner 10 and the bottom surface 501 of the chamber 50. In this case, the first foil 71 may be configured to provide protection for the bottom surface 501 and at least parts of the side surfaces of the chamber 50.

The chamber 50 with the stack (first joining partner 10, second joining partner 20, pre-layer 30) arranged therein and the foils 71, 72 lying flat against the chamber walls is schematically illustrated in Figure 6B. The chamber 50 may include a moving element 53. The moving element 53 may be arranged above the second joining partner 20, for example. The moving element 53 may be movable in a vertical direction. The vertical direction may be a direction perpendicular to the bottom surface 501 of the chamber 50. After creating a vacuum such that the first foil 71 and the second foil lie flat against the walls of the chamber 50 and before filling the liquid 60 into the chamber 50, the moving element 53 may be used to apply a pressure to the second joining partner 20. In this way, the pre-layer 30 may be pre-compacted before filling the liquid 60 into the chamber 50. By pre-compacting the pre-layer 30, the liquid 60 may be prevented from penetrating into voids that may be present in the pre-layer 30. By pre-compacting the pre-layer 30, the size of any voids that might be present in the pre-layer 30 may be reduced to make it more difficult for the liquid 60 to intrude into the pre-layer 30.

Pre-compacting the pre-layer 30, however, is only an example. According to another example, a protective layer (not illustrated in Figure 6) may be applied to the components, similar to the protective layer 70 that has been described with respect to Figure 4 above. The protective layer may cover all exposed surfaces of the joining partners 10, 20 and the pre-layer 30 or may cover only some of the exposed surfaces. For example, the protective layer may only cover the exposed surfaces of the pre-layer 30, in order to prevent the liquid from penetrating the pre-layer 30.

After closing the chamber 50, creating a vacuum such that the layers 71, 72 lie flat against the surfaces of the chamber 50, and, optionally, applying a protective layer or pre-compacting the pre-layer 30, the liquid 60 is filled into the chamber 60 to apply a pressure to the components (see Figure 6C). The process of filling the chamber 50 with liquid 60 and applying a pressure to the components is essentially the same as has been described above with respect to Figures 2 and 5. By applying a pressure to the components, the pre-layer 30 is compacted and then forms the compacted connection layer 31. The pressure inside the chamber may be at least 10MPa (100bar), at least 20MPa (200bar), or at least 30MPa (300bar), for example. The pressure may be a quasi-hydrostatic pressure.

The liquid 60 is a liquid polymer. For example, the liquid polymer may be a thermosetting polymer. However, the liquid polymer may possibly also be a thermoplastic polymer. These are, however, only examples. The liquid 60 may include any suitable material which may also function as a mold material, for example. Generally, after connecting the joining partners 10, 20 and placing the joining partners 10, 20 in a housing, the housing is filled with a mold material which protects the components from any damages or any environmental influences or impacts such as moisture or corrosive gases, for example. If no electrical connections such as bonding wires 21, for example, are present while performing the sintering process, such connections may be provided before arranging the joining partners 10, 20 in the housing and filling the housing with the mold material. In any case, an additional step is required, namely filling the housing with mold material.

To avoid this additional step, the liquid 60 is hardened or solidified during the sintering process that has been explained with reference to Figure 6C. By applying a pressure within the chamber 50 and heating the components as well as the liquid 60, the liquid 60 may form a solid or semi-solid block 61 which adheres to the joining partners 10, 20. This is schematically illustrated in Figure 6D. The joining partners 10, 20 as well as the connecting layer 31 and any electrical connections 21, 22, 23 may be molded into the block formed by the mold material 61 and form an entity. The components, enclosed by the mold material 61, may then be placed in a housing, for example. No additional molding step is necessary in this case, because the molding step has been performed at the same time as the sintering process and the liquid 60 fulfills two functions. Firstly, the liquid 60 is used to apply pressure to the joining partners 10, 20 to perform the sintering step and additionally, the liquid 60 is used as mold material.

If a moving element 53 is present in the chamber 50, the moving element 53 may further be used during the sintering process. For example, the moving element 53 may be moved towards the bottom surface 501 of the chamber 50 during the sintering process. This reduces the volume of the chamber 50 and increases the pressure within the chamber 50. The pressure distribution within the chamber may be controlled better by means of a movable element 53. For example, a pressure on the top surface of the second joining partner 20 may be increased by moving the movable element 53 towards the second joining partner 53 (see arrow in Figure 6C). The moving element 53 may also be used to reduce the volume of the mold material 61 and create product specific mold cavities 62 as is exemplarily illustrated in Figure 6D.

If a connecting element 23 is used to provide an electrical connection between the joining partners 10, 20 and the outside of the mold material 61, at least an end of the connecting element 23 may protrude from the chamber 50 during the mounting and molding process. This is exemplarily illustrated in Figures 6B and 6C. When filling the liquid 60 into the chamber 50, the liquid may run below the first joining partner 10 or in any unintentional gaps or cracks which may form at the point where the connecting element 23 protrudes from the chamber 50, for example. When the liquid 60 is subsequently hardened or solidified, this may lead to unwanted mold flashes. Such mold flashes may subsequently be removed. Removing mold flashes may include etching, grinding or polishing, for example.

Irrespective whether the solidified or hardened liquid 60 is removed after the sintering process (see Figures 2 and 5) or is used as a mold material 61 (see Figure 6), the method comprises filling the liquid 60 into the chamber 50 to apply a pressure inside the chamber 50 and thereby applying a force/pressure to the joining partners 10, 20 and to the pre-layer 30. An equal force may be applied to all the exposed surfaces of the components that are arranged within the chamber 50, regardless of their height. Therefore, any differences in height between different components that are arranged next to each other on the bottom surface 501 of the chamber 50 may be compensated. Any foils 71, 72 that are used to seal the chamber 50 are renewed after each mounting/sintering process. Therefore, the sealing of the chamber 50 may not wear out as might happen when the sealing is used for several subsequent mounting/sintering processes. If foils 71, 72 are used to protect at least some of the surfaces of the chamber 50 and/or the components, as has been explained with reference to Figures 5 and 6, no additional sealing may be necessary to seal the chamber 50. If only a protective layer 70 is used (see Figure 4) instead of foils 71, 72, any sealing may be used which is suitable to adequately seal the chamber 50. However, the liquid 60 itself may also function as a sealing if it has a certain viscosity. Using the liquid itself as a sealing provides substantial advantages over conventional methods. No additional complicated and, therefore, expensive seals are needed if the liquid itself functions as the sealing. Therefore, the costs of the methods are dramatically reduced as compared to conventional methods.

During the mounting/sintering process, which includes applying a force/pressure to the joining partners 10, 20 and, optionally, heating the chamber 50 with the components arranged therein, the liquid 60, which is a liquid polymer, is hardened or solidified. The hardened liquid 60 may subsequently be removed or may function as a mold material 61. If the hardened or solidified liquid 60 functions as mold material 61, no additional molding step is necessary which reduces the production time and the costs for producing a power semiconductor module arrangement.

One embodiment of the method of the invention comprises arranging the joining partners 10, 20 inside the chamber 50. For example, a first joining partner 10 may be arranged on a bottom surface 501 of the chamber 50 (first surface 101 of the first joining partner 10 facing the bottom surface 501). A pre-layer 30 is arranged on a surface (second surface 102) of the first joining partner 10 which faces away from the bottom surface 501. A second joining partner 20 is arranged on the pre-layer 30 such that the pre-layer 30 is arranged between the first joining partner 10 and the second joining partner 20. The chamber 50 may be closed and the liquid 60 is filled into the chamber 50. The liquid 60 may be under pressure and may be compressed such that it applies a pressure to the joining partners 10, 20. The second joining partner 20 is thereby pressed onto the first joining partner 10 and compresses the pre-layer 30 arranged between the joining partners 10, 20. Compressing the pre-layer 30 results in a (compressed) connecting layer 31 which forms a firm substance-to-substance bond between the joining partners 10, 20. The chamber 50 may be heated while applying pressure to the joining partners 10, 20. For example, the chamber 50 may be heated up to 150°C, up to 250°C, or up to 350°C. If heat is applied during the mounting/sintering process, the chamber 50 with the components arranged therein may subsequently be cooled. The chamber 50 may then be opened and the solidified or hardened liquid may either be removed or it may remain on the joining partners 10, 20 to form a mold material 61.

Before closing the chamber 50 and filling the liquid 60 into the chamber 50, optionally, protection layers 70 or foils 71, 72 may be arranged within the chamber 50. After closing the chamber 50, a vacuum may be generated to flatten the foils 71, 72 such that they lie flat against the walls of the chamber 50 and/or the exposed surfaces of the joining partners 10, 20. When filling the liquid 60 into the chamber 50, the foils 71, 72 may be arranged between the liquid 60 and the walls of the chamber 50 and/or between the liquid 60 and the joining partners 10, 20.

## Claims

1. A method comprising:
arranging a first joining partner (10) in a joining chamber (50), the first joining partner (10) comprising a first surface (101) and a second surface (102) opposite the first surface (102), the first surface (101) facing a bottom surface (501) of the joining chamber (50);
arranging a second joining partner (20) on the second surface (102) of the first joining partner (10), with a first pre-layer (30) being arranged between the first joining partner (10) and the second joining partner (20);
filling the joining chamber (50) with a liquid (60), thereby applying a pressure to the joining partners (10, 20) such that the second joining partner (20) is pressed onto the first joining partner (10), thereby compressing the pre-layer (30) resulting in a connecting layer (31) which forms a firm substance-to-substance bond between the first joining partner (10) and the second joining partner (20), wherein
the liquid (60) comprises a liquid polymer, and
the liquid (60) is solidified or hardened while applying pressure to the joining partners (10, 20).

2. The method of claim 1, wherein the pressure that is applied to the joining partners (10, 20) is at least 10MPa, at least 20MPa, or at least 30MPa.

3. The method of any of claims 1 to 2, wherein the pressure is applied evenly to the exposed surfaces of the joining partners (10, 20).

4. The method of any of the preceding claims, further comprising
heating the chamber (50).

5. The method of claim 4, wherein the chamber (50) is heated to up to 150°C, up to 250°C or up to 350°C.

6. The method of any of the preceding claims, further comprising
applying a protective layer (70) on at least some of the exposed surfaces of the first joining partner (10), the second joining partner (20) and the pre-layer (30), wherein the protective layer (70) is configured to protect at least parts of the joining partners (10, 20) and the pre-layer (30) from coming into contact with the liquid (60).

7. The method of claim 6, wherein the protective layer (70) includes a lubricant or an anti-tarnish coating.

8. The method of claim 6 or 7, wherein applying the protective layer (70) includes spraying, sputtering, dipping or brushing.

9. The method of any of the preceding claims, wherein the method further comprises
removing the solidified or hardened liquid (60) after forming the connection layer (31).

10. The method of any of claims 1 to 5, wherein the solidified or hardened liquid (60) adheres to the joining partners (10, 20) and is configured to function as a mold material (61) after forming the connection layer (31).

11. The method of any of the preceding claims, wherein the pre-layer (30) includes a paste and wherein the paste includes a metal powder.

12. The method of any of claims 1-9 and 11, further comprising:
arranging at least one foil (71, 72) within the chamber (50); and
generating a vacuum to draw in the at least one foil (71, 72) such that the at least one foil (71, 72) lies flat against at least one of a wall of the chamber (50), the first joining partner (10) and the second joining partner (20), wherein the at least one foil (71, 72) is configured to protect the at least one wall, the first joining partner (10) and the second joining partner (20) from getting into contact with the liquid (60).

13. The method of any of the preceding claims, further comprising:
pre-compacting the pre-layer (30) before filling the liquid (60) into the chamber (50).

14. The method of any of the preceding claims, wherein
the first joining partner (10) is a substrate and the second joining partner (20) is a semiconductor body;
the first joining partner (10) is a base plate and the second joining partner (20) is a substrate; the first joining partner (10) is a heat sink and the second joining partner (20) is a substrate; or
the first joining partner (10) is a substrate and the second joining partner (20) is a semiconductor wafer, wherein the substrate comprises a dielectric insulation layer (11), a first metallization layer (111) attached to the dielectric insulation layer (11), and a second metallization layer (112) attached to the dielectric insulation layer (11), wherein the dielectric insulation layer (11) is disposed between the first and second metallization layers (111, 112).

## Patentansprüche

1. Verfahren, umfassend:
Anordnen eines ersten Fügepartners (10) in einer Fügekammer (50), wobei der erste Fügepartner (10) eine erste Oberfläche (101) und eine zweite Oberfläche (102) gegenüber der ersten Oberfläche (102) umfasst, wobei die erste Oberfläche (101) zu einer unteren Oberfläche (501) der Fügekammer (50) zeigt;
Anordnen eines zweiten Fügepartners (20) auf der zweiten Oberfläche (102) des ersten Fügepartners (10), wobei eine erste Vorschicht (30) zwischen dem ersten Fügepartner (10) und dem zweiten Fügepartner (20) angeordnet ist;
Füllen der Fügekammer (50) mit einer Flüssigkeit (60), dadurch Ausüben eines Drucks auf die Fügepartner (10, 20), so dass der zweite Fügepartner (20) auf den ersten Fügepartner (10) gedrückt wird, dadurch Komprimieren der Vorschicht (30), um eine Bindungsschicht (31) zu ergeben, die eine feste Verbindung von Stoff zu Stoff zwischen dem ersten Fügepartner (10) und dem zweiten Fügepartner (20) bildet, wobei
die Flüssigkeit (60) ein flüssiges Polymer umfasst und
die Flüssigkeit (60) erstarrt oder gehärtet wird, während Druck auf die Fügepartner (10, 20) ausgeübt wird.

2. Verfahren gemäß Anspruch 1, wobei der Druck, der auf die Fügepartner (10, 20) ausgeübt wird, wenigstens 10 MPa, wenigstens 20 MPa oder wenigstens 30 MPA beträgt.

3. Verfahren gemäß einem der Ansprüche 1 bis 2, wobei der Druck gleichmäßig auf die freiliegenden Oberflächen der Fügepartner (10, 20) ausgeübt wird.

4. Verfahren gemäß einem der vorstehenden Ansprüche,
ferner umfassend Erhitzen der Kammer (50).

5. Verfahren gemäß Anspruch 4, wobei die Kammer (50) auf 150 °C, auf 250 °C oder auf 350 °C erhitzt wird.

6. Verfahren gemäß einem der vorstehenden Ansprüche, ferner umfassend
Aufbringen einer Schutzschicht (70) auf wenigstens manche der freiliegenden Oberflächen des ersten Fügepartners (10), des zweiten Fügepartners (20) und der Vorschicht (30), wobei die Schutzschicht (70) dafür gestaltet ist, wenigstens Teile der Fügepartner (10, 20) und der Vorschicht (30) vor Inkontaktkommen mit der Flüssigkeit (60) zu schützen.

7. Verfahren gemäß Anspruch 6, wobei die Schutzschicht (70) ein Schmiermittel oder eine Antianlaufbeschichtung enthält.

8. Verfahren gemäß Anspruch 6 oder 7, wobei das Aufbringen der Schutzschicht (70) Sprühen, Sputtern, Eintauchen oder Bürsten umfasst.

9. Verfahren gemäß einem der vorstehenden Ansprüche,
wobei das Verfahren ferner Entfernen der erstarrten oder gehärteten Flüssigkeit (60) nach dem Bilden der Verbindungsschicht (31) umfasst.

10. Verfahren gemäß einem der Ansprüche 1 bis 5, wobei die erstarrte oder gehärtete Flüssigkeit (60) an den Fügepartnern (10, 20) haftet und dafür gestaltet ist, nach dem Bilden der Verbindungsschicht (31) als Formmaterial (61) zu wirken.

11. Verfahren gemäß einem der vorstehenden Ansprüche, wobei die Vorschicht (30) eine Paste enthält und wobei die Paste ein Metallpulver enthält.

12. Verfahren gemäß einem der Ansprüche 1-9 und 11, ferner umfassend:
Anordnen wenigstens einer Folie (71, 72) in der Kammer (50); und
Erzeugen eines Unterdrucks, um die wenigstens eine Folie (71, 72) einzuziehen, so dass die wenigstens eine Folie (71, 72) flach an wenigstens einem von einer Wand der Kammer (50), dem ersten Fügepartner (10) und dem zweiten Fügepartner (20) anliegt, wobei die wenigstens eine Folie (71, 72) dafür gestaltet ist, die wenigstens eine Wand, den ersten Fügepartner (10) und den zweiten Fügepartner (20) vor Inkontaktkommen mit der Flüssigkeit (60) zu schützen.

13. Verfahren gemäß einem der vorstehenden Ansprüche, ferner umfassend:
Vorkompaktieren der Vorschicht (30) vor dem Füllen der Flüssigkeit (60) in die Kammer (50).

14. Verfahren gemäß einem der vorstehenden Ansprüche, wobei
der erste Fügepartner (10) ein Substrat ist und der zweite Fügepartner (20) ein Halbleiterkörper ist;
der erste Fügepartner (10) eine Grundplatte ist und der zweite Fügepartner (20) ein Substrat ist;
der erste Fügepartner (10) eine Wärmesenke ist und der zweite Fügepartner (20) ein Substrat ist; oder
der erste Fügepartner (10) ein Substrat ist und der zweite Fügepartner (20) ein Halbleiterwafer ist; wobei das Substrat eine dielektrische Isolationsschicht (11), eine an der dielektrischen Isolationsschicht (11) befestigte erste Metallisierungsschicht (111) und eine an der dielektrischen Isolationsschicht (11) befestigte zweite Metallisierungsschicht (112) umfasst, wobei die dielektrische Isolationsschicht (11) zwischen der ersten und der zweiten Metallisierungsschicht (111, 112) angeordnet ist.

## Revendications

1. Procédé comprenant :
mettre un premier partenaire (10) de jonction dans une chambre (50) de jonction, le premier partenaire (10) de jonction comprenant une première surface (101) et une deuxième surface (102) opposée à la première surface (101), la première surface (101) faisant face à une surface (501) de fond de la chambre (50) de jonction ;
mettre un deuxième partenaire (20) de jonction sur la deuxième surface (102) du premier partenaire (10) de jonction avec une première pré-couche (300) disposée entre le premier partenaire (10) de jonction et le deuxième partenaire (20) de jonction ;
remplir la chambre (50) de jonction d'un liquide (60), en appliquant ainsi une pression aux partenaires (10, 20) de jonction de manière à presser le deuxième partenaire (20) de jonction sur le premier partenaire (10) de jonction, en comprimant ainsi la pré-couche (30), ce qui donne une couche (31) de liaison, qui forme une liaison ferme de substance à substance entre le premier partenaire (10) de jonction et le deuxième partenaire (20) de jonction, dans lequel
le liquide (60) comprend un polymère liquide et
le liquide (60) est solidifié ou durci alors que l'on applique une pression aux partenaires (10, 20) de jonction.

2. Procédé suivant la revendication 1, dans lequel la pression qui est appliquée aux partenaires (10, 20) de jonction est d'au moins 10 MPa, d'au moins 20 MPa ou d'au moins 30 MPa.

3. Procédé suivant l'une quelconque des revendications 1 à 2, dans lequel on applique la pression également aux surfaces à découvert des partenaires (10, 20) de jonction.

4. Procédé suivant l'une quelconque des revendications précédentes, dans lequel en outre
on chauffe la chambre (50).

5. Procédé suivant la revendication 4, dans lequel on chauffe la chambre (50) jusqu'à 150°C, jusqu'à 250°C ou jusqu'à 350°C.

6. Procédé suivant l'une quelconque des revendications précédentes, dans lequel en outre
on applique une couche (70) de protection à au moins certaines des surfaces à découvert du premier partenaire (10) de jonction, du deuxième partenaire (20) de jonction et de la pré-couche (30), la couche (70) de protection étant configurée pour empêcher au moins des parties des partenaires (10, 20) de jonction et de la pré-couche (30) de venir en contact avec le liquide (60).

7. Procédé suivant la revendication 6, dans lequel la couche (70) de protection comprend un lubrifiant ou un revêtement contre le ternissement.

8. Procédé suivant la revendication 6 ou 7, dans lequel appliquer la couche (70) de protection comprend une pulvérisation cathodique, une immersion, un brossage.

9. Procédé suivant l'une quelconque des revendications précédentes, dans lequel le procédé comprend en outre
retirer le liquide (60) solidifié ou durci après avoir formé la couche (71) de liaison.

10. Procédé suivant l'une quelconque des revendications 1 à 5, dans lequel le liquide (60) solidifié ou durci adhère aux partenaires (10, 20) de jonction et est configuré pour servir de matière (61) à mouler après avoir formé la couche (31) de liaison.

11. Procédé suivant l'une quelconque des revendications précédentes, dans lequel la pré-couche (30) comprend une pâte et dans lequel la pâte comprend une poudre métallique.

12. Procédé suivant l'une quelconque des revendications 1 à 9 et 11, dans lequel en outre :
on met au moins une feuille (71, 72) métallique dans la chambre (50) ; et
on produit un vide pour tirer à l'intérieur la au moins une feuille (71, 72) métallique de manière à ce que la au moins la une feuille (71, 72) métallique s'applique à plat sur au moins l'un d'une paroi de la chambre (50), du premier partenaire (10) de jonction et du deuxième partenaire (20) de jonction, la au moins une feuille (71, 72) métallique étant configurée pour empêcher la au moins une paroi, le premier partenaire (10) de jonction et le deuxième partenaire (20) de jonction de venir en contact avec le liquide (60).

13. Procédé suivant l'une quelconque des revendications précédentes, dans lequel en outre :
on pré-compacte la pré-couche (30) avant de remplir la chambre (50) du liquide (60).

14. Procédé suivant l'une quelconque des revendications précédentes, dans lequel
le premier partenaire (10) de jonction est un substrat et le deuxième partenaire (20) de jonction est un corps semiconducteur ;
le premier partenaire (10) de jonction est une plaque de base et le deuxième partenaire (20) de jonction est un substrat ;
le premier partenaire (10) de jonction est un puits de chaleur et le deuxième partenaire (20) de jonction est un substrat ou
le premier partenaire (10) de jonction est un substrat et le deuxième partenaire (20) de jonction est une tranche de semiconducteur, dans lequel le substrat comprend une couche (11) diélectrique isolante, une première couche (111) de métallisation adjointe à la couche (11) diélectrique isolante et une deuxième couche (112) de métallisation adjointe à la couche (11) diélectrique isolante, la couche (11) diélectrique isolante étant disposée entre la première et la deuxième couches (111, 112) de métallisation.
